Europäisches Patentamt

European Patent Office

Office européen des brevets

Publication number: **0 304 116**
**A1**

# EUROPEAN PATENT APPLICATION

Application number: **88201686.8**

Date of filing: **04.08.88**

Int. Cl.⁴: **H01L 39/24 , H01L 39/14 , H01B 12/06 , H01L 39/12 , C04B 35/00**

Priority: **12.08.87 NL 8701890**

Date of publication of application:
**22.02.89 Bulletin 89/08**

Designated Contracting States:
**DE FR GB IT NL SE**

Applicant: **N.V. Philips' Gloeilampenfabrieken**
**Groenewoudseweg 1**
**NL-5621 BA Eindhoven(NL)**

Inventor: **Zalm, Peter Cornelis**
**c/o INT. OCTROOIBUREAU B.V. Prof.**
**Holstlaan 6**
**NL-5656 AA Eindhoven(NL)**

Representative: **Weening, Cornelis et al**
**INTERNATIONAAL OCTROOIBUREAU B.V.**
**Prof. Holstlaan 6**
**NL-5656 AA Eindhoven(NL)**

**Method of manufacturing a superconductive wire or cable.**

A layer of a solution (6) of the compounds of the composing elements of the suprconductive material in an inert solvent, as well as a precipitant which forms a precipitate with the compounds, is provided on an inert, elongated carrier body (2), for example, an Ag wire, the wire is heated after removing the solvent, the formed precipitate being converted into a layer of the superconductive material.

EP 0 304 116 A1

## Method of manufacturing a superconductive wire or cable

The invention relates to a method of manufacturing a wire or cable of a superconductive material of the oxidic type.

Such a method is described in the Herald Tribune of 10-4-1987. In this article it is described that it must be deemed possible to manufacture wires of superconductive oxidic material by means of a drawing process in which thin filaments are drawn which can be clad with metal, for example, Cu.

The superconductive oxidic material as such is known from various publications. Reference may be made, inter alia, to the first publication in this field by J. G. Bednorz and K.A. Müller in Zeitschrift für Physik B, Condensed Matter 64, pp. 189-193 of September, 1986. In this first publication is described the superconductive character of substances of the La-Ba-Cu-O system at comparatively high Tg. It is known from later publications, for example, Physical Review Letters 58, No. 9, pp. 908-910 (1987), that other oxidic (ceramic) materials also show superconductivity at a comparatively high Tg of, for example, 80-90° K, for example, substances of the Y-Ba-Cu-O system. As is also stated in the last-mentioned publication, Ba may be replaced by Sr.

It appears from, further publications, for example, Physical Review Lettes 58, No. 16, pp. 1676-1679 (1987) and International Business Week of April 6, 1987, pp. 54-60, that the best suitable method of preparing the superconductive oxidic material in bulk form consists in that the oxides and/or carbonates of the composing elements of the superconductive material are mixed and ground in powder form. The mixture is heated and compressed to pellets or cylinders and then sintered at a high temperature in an oxygen atmosphere. As is suggested in the first-mentioned publication, very thin filaments can be drawn from these products.

It is the object of the invention to provide a new method of manufacturing superconductive wires or cables which presents advantages with respect to the known method.

A first object of the invention is a method of preparing in which fewer process steps are necessary and in which in particular no separate first process step is necessary in which pellets, cylinders or other moulded bodies of the superconductive material are manufactured.

A second object is a method of manufacturing wires and cables in which a comparatively small quantity of the superconductive material suffices.

According to another object a method is provided in which wires and cables of different diameters and different configurations for example, a spiral-like configuration, are manufactured in a single manner.

A further object relates to a method of manufacturing superconductive wires and cables in which the physical properties of the manufactured product, for example. tensile strength, thermal conductivity, normal electric conductivity, coefficient of expansion and the like can be selected and realised at will in an efficacious and simple manner.

These and other objects, for example, the possibility of internal cooling of wires and cables manufactured according to the invention, are achieved by means of a method of the type mentioned in the opening paragraph which is characterized in that a wire-shaped inert carrier body is provided with a thin layer of a solution which comprises an inert solvent in which chemical compounds of the composing elements of the superconductive material have been dissolved, as well as a reagent which is soluble in the solvent and forms aprecipitate with the said compounds, the solvent is removed and the carrier body with the layer of the formed precipitate present thereon is subjected to a thermal treatment, the precipitate being converted into a layer of a superconductive material.

An aqeous solution is preferably used of water-soluble salts of the composing elements, for example, an aqueous solution which comprises Ba (or Sr) nitrate, La (or Y) nitrate and Cu-nitrate in quantities which correspond to the atomic weight percentages of the elements in question is the superconductive material. A water-soluble reagent, in particular oxalic acid, citric acid or a water-soluble oxalate, citrate or carbonate is preferaly added directly to this solution. The oxalates, and citrates or carbonates, respectively, of the composing elements are formed in the thin layer of the aqueous solution which do not dissolve in the reaction medium and form a thin layer of precipitate. The solvent is removed either as a result of spontaneous evaporation, or by evaporation at elevated temperature and/or by using a dry, inert gas atmosphere.

The subsequent thermal treatment in which the oxalates and citrates or carbonates, respectively, decompose and the product is fixed to form the superconductive oxidic material takes place at approximately 900-1100° C in an oxygen-containing atmosphere.

The wire-shaped carrier body used in the method according to the invention is inert. This means that no or no noteworthy interaction occurs with the thin layer of superconductive material. In fact, if interaction does take place, the composition of the superconductive layer can be changed to form a non-active compound. Another requirement which is imposed upon the carrier body is that it can withstand the temperature at which the firing mentioned hereinbefore and optionally sintering take place. The advantage of the invention is that the wire-shaped inert carrier body is decisive of notably the mechanical and physical properties of the manufactured wire or cable. A variety of desired properties of the final product - superconductive wire or cable - can simply be realised by a suitable choice of the material and the configuration of the carrier body. Examples of such properties are tensile strength, flexibility, thermal conductivity, electrical conductivity, specific gravity.

The carrier body may furthermore comprise auxiliary members, for example, connectors, splitters, terminations and the like which are desired for practical applications. By way of example, the carrier body may also comprise one or more ducts or bores which may be used for internal cooling of the wire or cable by means of liquid nitrogen flowing through the ducts. If desired, electric or optical conductors or, for example, reinforcing fibres may be accomodated in the ducts or bores. It is also possible to provide a suitable configuration which is desired for the final product, for example, a spiral-like winding of the carrier body, already in the carrier body. Preferably an inert carrier body is used which comprises one or more wires of Ag or Au or comprises a core covered with a layer of Ag or Au. Such a core for example, comprises one or more threads of a non-noble metal such as Cu, Ni, Al and stainless steel or of quartz. Due to its excellent electrical conductivity the use of a Cu core is advantageous.

In a favourable embodiment the method according to the invention is characterized in that an inert carrier body is used comprising one ore more wires of Ag or Au or comprising a core covered with a layer of Ag or Au, which carrier body is provided, by means of spraying or atomising process, with a thin layer of an aqueous solution of water-soluble salts of the composing elements and with a reagent which forms a precipitate with the salts, the solvent is removed and the fibre is heated in an oxygen atmosphere, the formed precipitate being converted into a thin layer of a superconductive material of the oxidic type.

By using the spraying or atomising process, a very uniform thin layer is provided over the whole circumference of the wire-shaped carrier body. The inert carrier body used does not show any interaction with the provided superconductive layer of oxidic material.

It is to be noted that it is known from the publication in Zeitschrift für Physik B mentioned hereinbefore to prepare the oxidic material of the La-Ba-Cu-O system by coprecipitation of aqueous solutions of Ba-, La-, and Cu-nitrate by means of an aqueous solution of oxalic acid. The precipitated oxalates are decomposed by heating and converted into the desired oxidic material. It relates here to the preparation of the material as such, hence in bulk form, and not, as in the present invention, to the manufacture of wires or cables in which carrier elements and thin layers provided hereon have an essential meaning.

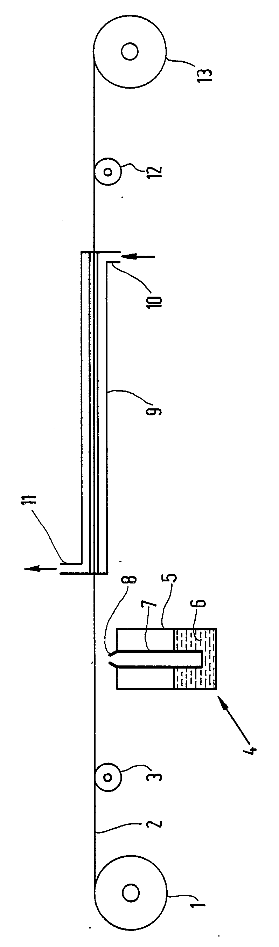

The invention will now be described in greater detail with reference to the specific example and the drawing, the sole Figure of which is a diagrammatic representation of the process according to the invention.

Reference numeral 1 in the figure denotes a storage reel comprising an Ag wire 2. After unreeling from reel 1, the Ag wire 2 passes, via guide rollers 3, a liquid atomiser 4. The liquid atomiser 4 which is shown very diagrammatically in the Figure comprises a holder 5 in which a liquid 6 to be atomised is present which is atomised on Ag wire 2 via rise pipe 7 and nozzle 8. The spray liquid comprises an aqueous solution of yttrium nitrate, barium nitrate and copper nitrate in quantities which correspond to the atomic fraction of the element in question in the desired superconductive material in this case $Ba_2YCu_3O_9\text{-}\delta$, wherein $\delta = 2.1 \pm 0.05$. Oxalic acid has also been added to the solution. A precipitate of yttrium oxalate, barium oxalate and copper oxalate is formed in the liquid layer provided on the Ag wire 2. The liquid layer is dried in air and Ag wire 2 is then passed through a furnace 9 which has an inlet aperture 10 and an outlet aperture 11 for oxygen gas. Ag wire 2 is heated in the oxygen atmosphere of furnace 9 to a temperature of approximately 1100° C. The layer of the homogenous mixture of oxalates present on Ag wire 2 is converted into the superconductive material $Ba_2YCu_3O_9\text{-}\delta$, wherein $\delta = 2.1 \pm 0.05$. The Ag wire 2 comprising a superconductive layer is reeled on a storate reel 13 via guide rollers 12.

## Claims

1. A method of manufacturing a wire or cable of a superconductive material of the oxidic type, characterized in that a wire-shaped inert carrier body is provided with a thin layer of a solution which comprises an inert solvent in which chemical compounds of the composing elements of the superconductive material have been dissolved, as well as a reagent which is soluble in the solvent and forms a precipitate with the said compounds, the solvent is removed and the carier body with the layer of the formed precipitate present thereon is subjected to a thermal treatment. the precipitate being converted into a layer of superconductive material.

2. A method as claimed in Claim 1, characterized in that an inert carrier body is used, comprising one ore more wires of Ag or Au or comprising a core covered with a layer of Ag or Au, which carrier body is provided, by means of a spraying or atomising process, with a thin layer of a aqueous solution of water-soluble salts of the composing elements and with a reagent which forms a precipitate with the salts, the solvent is removed and the fibre is heated in an oxygen atmosphere, the formed precipitate being converted into a thin layer of a superconductive material of the oxidic type.

European Patent Office

**EUROPEAN SEARCH REPORT**

Application Number

EP 88 20 1686

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,A | ZEITSCHRIFT FÜR PHYSIK B - condensed matter 64, September 1986, pages 189-193, Springer-Verlag, Berlin, DE; J.G. BEDNORZ et al.: "Possible high Tc superconductivity in the Ba-La-Cu-O system"<br>* Page 190, paragraph II.1 * | 1,2 | H 01 L 39/24<br>H 01 L 39/14<br>H 01 B 12/06<br>H 01 L 39/12<br>C 04 B 35/00 |
| A | JAPANESE JOURNAL OF APPLIED PHYSICS, vol. 26, no. 4, part 2, 20th April 1987, pages L454-L455, Tokyo, JP; M. HIRABAYASHI et al.: "Structure and superconductivity in a new type of oxygen deficient perovskites Y1Ba2Cu3O7"<br>* Whole article * | 1,2 | |
| A | ADVANCED CERAMIC MATERIALS, vol. 2, no. 3B, 1987, pages 388-400, Westerville, OH, US; R.W. McCALLUM et al.: "Problems in the production of YBa2Cu3Ox superconducting wire"<br>* Page 389, lines 8-10 * | 1,2 | |
| A | APPLIED PHYSICS LETTERS, vol. 51, no. 3, 20th July 1987, pages 203-204, American Institute of Physics, New York, US; S. JIN et al.: "High Tc superconductors - composite wire fabrication"<br>* Page 204, left-hand column, lines 16-23 * | 2 | |
| A | EP-A-0 180 936 (BROWN, BOVERI & CIE A.G.) | | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 21-11-1988 | MORVAN D.L.D. |